# EUROPÄISCHE PATENTSCHRIFT

(11) **EP 1 059 701 B1**
(45) Veröffentlichungstag und Bekanntmachung des Hinweises auf die Patenterteilung: **26.10.2005**
(21) Anmeldenummer: 00109488.7
(22) Anmeldetag: 04.05.2000
(51) Int. Cl.: H01R 13/645, H01R 12/16

(54) **Kodiereinrichtung**
Coding device
Dispositif de codage

(30) Priorität: 02.06.1999 DE 19925347
(43) Veröffentlichungstag der Anmeldung: 13.12.2000
(73) Patentinhaber: Harting Electronics GmbH & Co. KG, 32339 Espelkamp (DE)
(72) Erfinder: Harting, Dietmar, Dipl.-Kfm., 32339 Espelkamp (DE); Pape, Günter, Dipl.-Ing., 32130 Enger (DE); Weichert, Frank, Dipl.-Ing., 32312 Lübbecke (DE); Kohler, Andreas, Dipl.-Ing., 32423 Minden (DE)

(56) Entgegenhaltungen:
- US-A- 5 030 141
- US-A- 5 346 412

## Beschreibung

Die Erfindung betrifft eine Kodiereinrichtung für mechanisch zusammenfügbare Teile, insbesondere Leiterplattensteckverbinder, wobei die zu verbindenden Teile jeweils mit mindestens einem Kodierelement versehen sind, sowie ein Verfahren zum Kodieren von zwei mechanisch zusammenfügbaren Teilen.

Eine Kodierung von mechanisch zusammenfügbaren Teilen, wie z.B. Steckverbindungen ist erforderlich, um einen unverwechselbaren Aus- oder Umtausch dieser Teile vornehmen zu können und um die Funktionalität der mit diesen Teilen verbundenen Einheiten, z.B. elektrische Steuerungen auf Leiterplatten, sicherzustellen.

Es ist bekannt Leiterplattensteckverbinder mit mechanischen Kodiereinrichtungen auszurüsten, um eine Verwechslung unterschiedlicher Leiterplatten zu verhindern. Dabei werden Stifte, Scheibchen oder sonstige Formteile, so in entsprechende Ausnehmungen innerhalb oder außerhalb einer Steckverbindung ein- oder angebracht, daß das Einstecken einer nicht korrekt kodierten Steckverbindung verhindert wird. Eine solche Kodiereinrichtung ist bekant aus Dokument US-A-5 030 141.

Problematisch werden die bekannten Kodiereinrichtungen bei der zunehmenden Miniaturisierung der Steckverbinder, da die entsprechenden Kodiereinrichtungen immer kleiner und diffiziler ausgeführt werden müssen, wobei die Kodiereinrichtungen teilweise mit einem Spezialwerkzeug gesteckt und wieder entfernt werden müssen.

Zudem besteht die Gefahr, daß bei einem gewaltsamen Steckvorgang relativ kleine Kodiereinrichtungen zerstört werden und deren Schutzwirkung nicht mehr gewährleistet ist.

Dieser Erfindung liegt daher die Aufgabe zugrunde, eine Kodiereinrichtung zur Kodierung von mechanisch verbindbaren Teilen der eingangs genannten Art derart auszubilden, daß mit einer einfachen und werkzeuglosen Montage eine sichere Kodierung der Verbindung erfolgt.

Diese Aufgabe wird dadurch gelöst, daß jeweils zwei zusammengehörige Kodierelemente als einstückiges Kodiermodul ausgebildet sind, wobei die Kodierelemente mittels stegartiger Verbindungen zusammengehalten sind.

Vorteilhafte Ausgestaltungen sind in den Ansprüchen 2 - 4 angegeben. Im Anspruch 5 ist ein Verfahren zum Kodieren von zwei mechanisch zusammenfügbaren Teilen angegeben.

Die mit der Erfindung erzielten Vorteile bestehen insbesondere darin, daß die Kodiereinrichtung zur Kodierung von mechanisch verbindbaren Teilen, wie u. a. Leiterplattensteckverbindern, bei der Montage zunächst mit der einen Leiterplatte verbunden wird und beim Zusammenstecken der Steckverbindung, mittels eines Befestigungsmittels an der Kodiereinrichtung, auf die andere Leiterplatte aufgepreßt wird.
Während des Preßvorganges zerbrechen die Stege, mit denen die beiden Kodierelemente zu einem Kodiermodul zusammengehalten werden, und die Verbindung ist wieder lösbar und gleichzeitig kodiert.
Dabei ist von Vorteil, daß für diesen Vorgang kein spezielles Werkzeug benötigt wird.
Weiterhin ist von Vorteil, daß durch eine massive und stabile Ausführung der beliebig in Form und Farbe wählbaren Kodiermodule, keine mechanische Zerstörung der Kodierelemente während eines Steckvorganges zu erwarten ist.

Besonders vorteilhaft ist, daß ein manuelles Ab- oder Ausbrechen von Kodierelementen entfällt, wenn die Kodierung von zusammengehörigen Steckverbindern von zwei Leiterplatten aufeinander abgestimmt werden soll.

Weiterhin ist von Vorteil, dass eine fehlerhafte Kodierung der Steckverbinder, die bei einer getrennten, bzw. unabhängigen Fertigung von zusammengehörigen Leiterplatten auftreten kann, vermieden wird, da bei der endgültigen Fertigstellung derartiger mit kodierten Steckverbindern ausgerüsteten Geräten, die Endmontage durch entsprechend versierte Fachleute durchgeführt wird, bei denen eine Fehlsteckung weitestgehend auszuschließen ist.

Bei dem erfindungsgemäßen Verfahren ist von Vorteil, daß das Kodiermodul zunächst erst an einem der verbindbaren Teilen befestigt wird und beim Zusammenfügevorgang mit dem anderen Teil, mit diesem automatisch fest verbunden wird, wobei mit dem Zusammenfügevorgang gleichzeitig die beiden Kodierelemente getrennt werden, so daß die zusammengefügten Teile jetzt in kodierter Ausführung wieder getrennt werden können.

Ein Ausführungsbeispiel ist in der Zeichnung dargestellt und wird im folgenden näher erläutert. Es zeigen:
- Fig. 1 - 4: Kodiermodule mit verschiedenen Kodierungsausführungen,
- Fig. 5 - 7: eine Montagefolge von Leiterplattensteckverbindern mit Kodierelementen,
- Fig. 8: den Trennvorgang einer kodierter Leiterplattensteckverbindung,
- Fig. 9: die Ansicht eines montierten, modifizierten Kodiermoduls, und
- Fig. 10: die Detailansicht eines Kodiermoduls und eines Leiterplattensteckverbinders vor der Montage auf einer Leiterplatte.

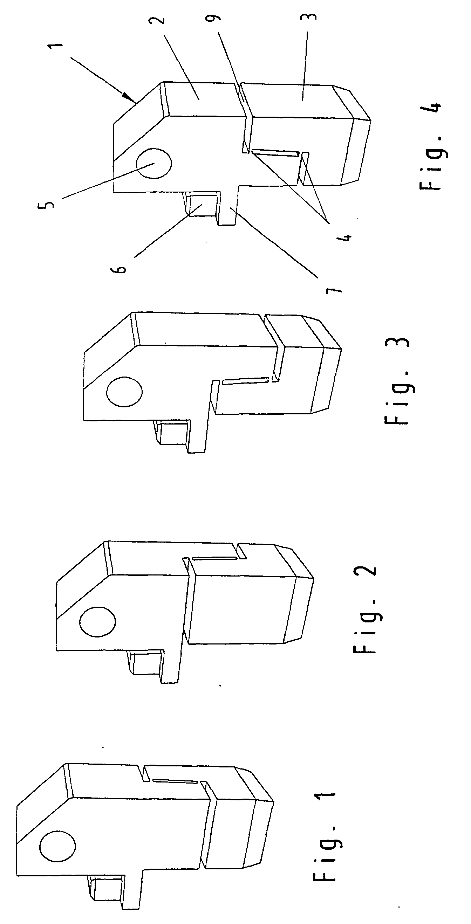

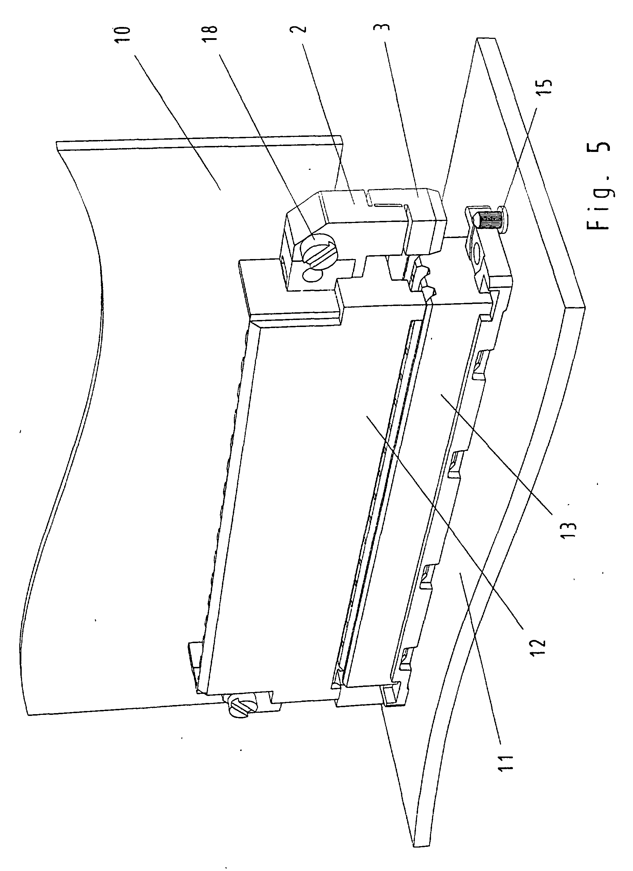

In den Fig. 1 - 4 sind Kodiermodule in verschiedenen Ausführungsformen dargestellt, die für eine Kodierung eines Leiterplattensteckverbinders vorgesehen sind.
Dabei ist die Formgebung der unterschiedlichen Kodierschlüssel grundsätzlich beliebig und den erforderlichen Gegebenheiten anpaßbar.
Das Kodiermodul 1 in der Fig. 4 ist z.B. als quaderförmiger Block ausgeführt und besteht aus zwei Teilen, den Kodierelementen 2 und 3, die durch stegartige Verbindungen 4 miteinander verbunden sind.
Dabei sind die Kodierelemente mit einem gleichmäßigen Abstand, bzw. durch einen Spalt 9 getrennt voneinander gehalten, wobei die Ausrichtung der stegartigen Verbindungen 4 vorzugsweise senkrecht zur Steckrichtung ausgeführt ist.
Wird auf die Kodierelemente eine Druckkraft in Steckrichtung ausgeübt, bis die zunächst durch den Spalt 9 beabstandeten Kodierelemente formschlüssig aufeinandertreffen, zerbrechen die stegartigen Verbindungen 4 und das Kodiermodul 1 wird in zwei einzelne Kodierelemente 2 und 3 aufgeteilt.

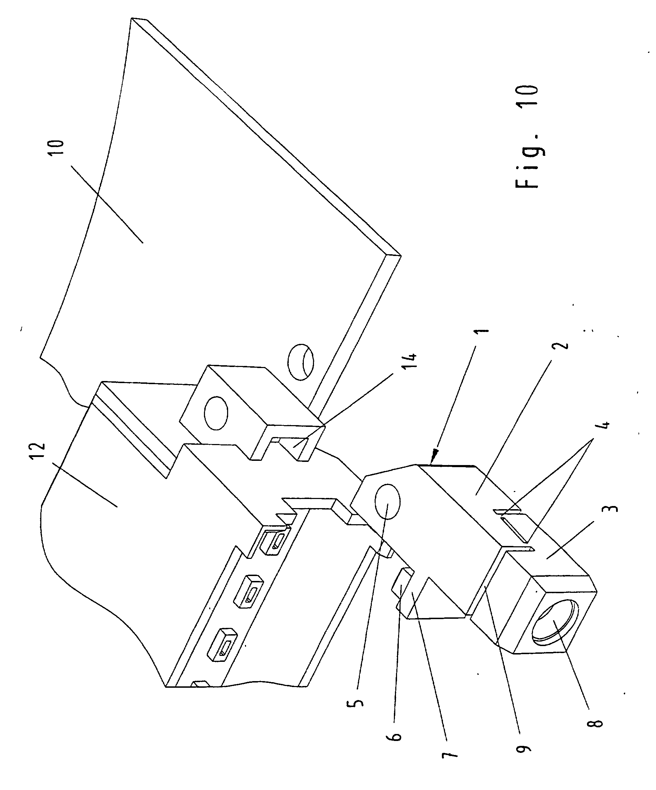

An dem in der Fig. 4 dargestellten Block des Kodiermodules 1, ist an einer Seite, etwa mittig zur Gesamthöhe des Kodiermoduls, ein Vorsprung 7 angeformt , auf dem ein Führungselement 6 angeordnet ist.
Dieses Führungselement 6 ragt bei einer Montage des Kodiermoduls auf einer Leiterplatte 10, in eine entsprechende Ausnehmung 14 eines Leiterplattensteckverbinders 12 hinein, und dient zunächst einer Vormontage von Kodiermodul 1 und Leiterplattensteckverbinder 12, bevor das Kodiermodul mit dem Kodierelement 2 mittels eines Befestigungsmittels 18 durch eine Bohrung 5 mit einer Leiterplatte 10 befestigt wird. (siehe hierzu auch Fig. 10)

In den Fig. 5, 6 und 7 ist der Zusammenfügevorgang einer Leiterplattensteckverbindung bestehend aus den Steckverbindern 12, 13 an den Leiterplatten 10, 11 und einem Kodiermodul 1 dargestellt.
Dabei ist vorgesehen, daß auf der Leiterplatte 11 bereits ein als Stift ausgebildetes Befestigungselement 15 vormontiert ist, das später in eine bodenseitige Bohrung 8 des Kodierelementes 3 eingepreßt wird.

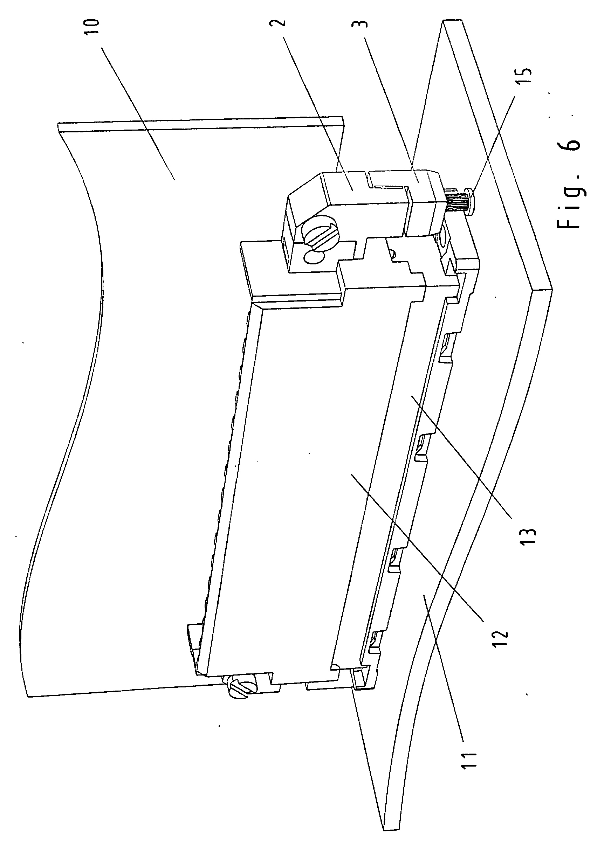

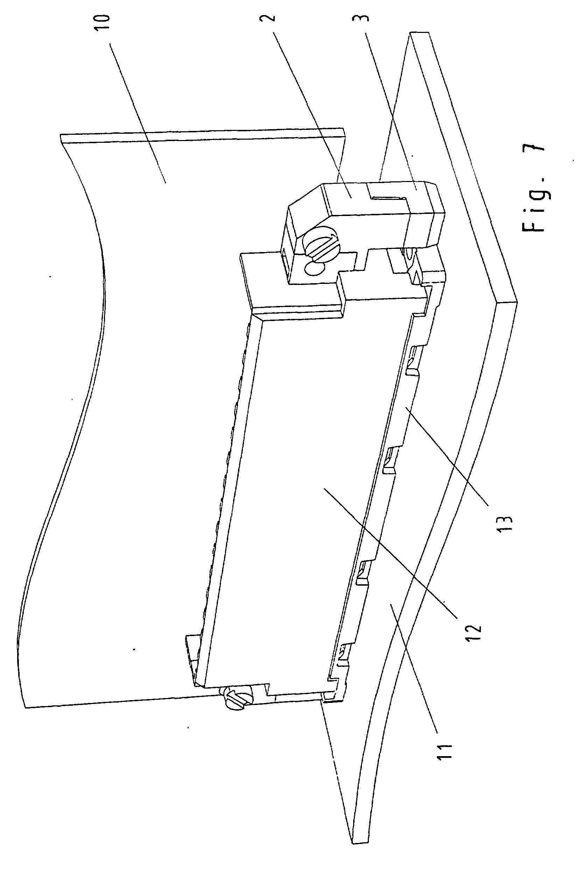

In dem Ausführungsbeispiel sind beidseitig eines Leiterplattensteckverbinders 12 zwei Kodiermodule 1 an der Leiterplatte 10 befestigt.
Werden die Steckverbinder 12, 13 der Leiterplatten 10, 11 zusammengesteckt, wird der Stift 15 dauerhaft in die entsprechende Bohrung 8 im Kodierelement 3 eingepreßt. (Fig. 6 und Fig. 7)
Während des Steckvorganges der Steckverbinder 12, 13 und des gleichzeitigen Einpreßvorganges des Stiftes 15 in die Bohrung 8 des Kodierelementes 3 des Kodiermoduls 1, werden durch die auftretenden Druckkräfte, die stegartigen Verbindungen 4 zwischen den beiden Kodierelementen gedehnt bis sie zerbrechen und die beiden Kodierelemente fest aneinandergefügt sind. (Fig. 7)
Damit ist die Verbindung der zusammengehörigen Kodierelemente 2, 3 getrennt und eine automatische Kodierung der Steckverbindung eingetreten. Die Steckverbindung zwischen der Leiterplatte 10 und der Leiterplatte 11 kann bei Bedarf sofort wieder gelöst werden, wobei die Kodierung nur noch eine Verbindung von Leiterplatten in dieser Kombination von Steckverbinder und Kodierelement zuläßt.

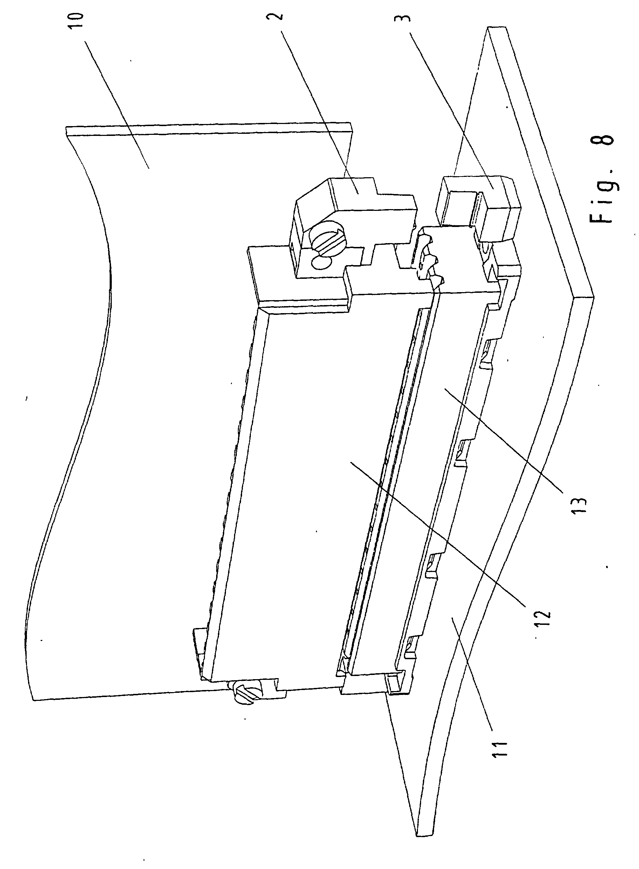

In der Fig. 8 ist ein Trennvorgang einer kodierten Steckverbindung gezeigt, wobei das Kodierelement 3 fest auf der Leiterplatte 11 mit dem Steckverbinder 13 verbleibt, während das Kodierelement 2 an der Leiterplatte 10 mit der Steckverbindung 12 befestigt ist.

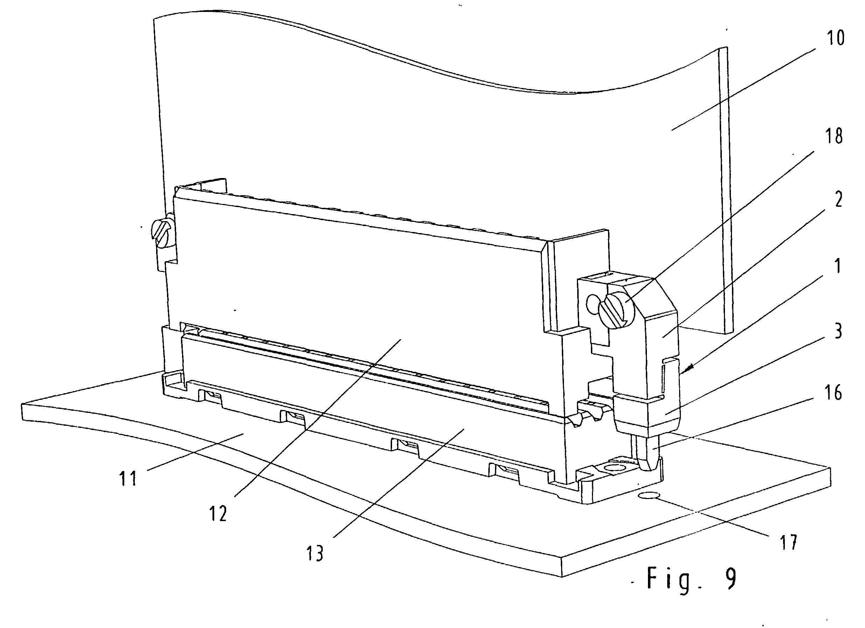

In der Fig. 9 ist eine Variante der zuvor beschriebenen Montage der Kodiermodule dargestellt.
Hierbei ist vorgesehen, daß in der Leiterplatte 11 eine entsprechend angeordnete Bohrung 17 vorgesehen ist, so daß ein im Kodierelement 3 des Kodiermoduls 1 fest eingelassener oder auch angeformter Einpreßstift 16 in die Bohrung 17 einpreßbar ist.
Bei dieser Montageart wird das Kodiermodul 1 zunächst ebenfalls auf der Leiterplatte 10 mittels des Befestigungsmittels 18 fixiert und die Steckverbinder 12, 13 der Leiterplatten 10, 11 ineinander gesteckt. Dabei preßt sich der montierte Einpreßstift 16 dauerhaft in die vorgesehene Bohrung 17 der Leiterplatte 11 ein, die stegartigen Verbindungen 4 zerbrechen und geben die Verbindung zwischen den Kodierelementen 2 und 3 frei.

In der Fig. 10 sind in einer Detailzeichnung ein Leiterplattensteckverbinder 12 und ein Kodiermodul 1 vor der Montage auf einer Leiterplatte 10 dargestellt.
Hier ist noch einmal deutlich das Führungselement 6 auf dem Vorsprung 7 zu erkennen, das in die Ausnehmung 14 am Leiterplattensteckverbinder 12 einhakt und mittels eines hier nicht dargestellten Befestigungsmittels 18 durch die Bohrung 5 des Kodierelementes 2 mit der Leiterplatte 10 eine sichere und stabile Verbindung ergibt.

Im folgenden wird ein Verfahren zur Kodierung von zwei mechanisch zusammenfügbaren Teilen 10, 11 beschrieben, wobei ein aus zwei Kodierelementen 2, 3 bestehendes, mit stegartigen Verbindungen 4 zusammengehaltenes Kodiermodul 1 mit den Teilen 10, 11 verbunden wird.
Dabei wird zunächst das Kodierelement 2 an dem ersten Teil 10 befestigt. Daraufhin werden die Teile 10 und 11 zusammengefügt, wobei gleichzeitig das Kodierelement 3 mit dem Befestigungsmittel 15 auf dem zweiten Teil 11 fixiert wird. Durch eine weiter aufgebrachte Druckkraft auf die zusammengefügten Teile 10 und 11, werden die durch die Stege 4 beabstandet gehaltenen Kodierelemente 2, 3 gegeneinandergedrückt, so daß die Stege abgeschert werden und zerbrechen und gleichzeitig wird das Kodierelement 3 mittels des Befestigungsmittels 15 dauerhaft auf dem zweiten Teil 11 befestigt.
Damit ist eine lösbare und kodierte Verbindung zwischen dem ersten und zweiten Teil 10, 11 entstanden, wobei das zweite Teil 11 mit dem Kodierelement 3 und das erste Teil 10 mit dem Kodierelement 2 verbunden bleibt.

## Patentansprüche

1. Kodiereinrichtung für mechanisch zusammenfügbare Teile, insbesondere Leiterplattensteckverbinder, wobei die zu verbindenden Teile jeweils mit mindestens einem Kodierelement versehen sind, **dadurch gekennzeichnet,**
**daß** jeweils zwei zusammengehörige Kodierelemente (2, 3) als einstückiges Kodiermodul (1) ausgebildet sind, wobei die Kodierelemente mittels stegartiger Verbindungen (4) zusammengehalten sind.

2. Kodiereinrichtung nach Anspruch 1, **dadurch gekennzeichnet,**
**daß** die Kodierelemente (2, 3) des Kodiermoduls (1) durch die stegartigen Verbindungen (4) beabstandet gehalten sind.

3. Kodiereinrichtung nach Anspruch 1 oder 2, **dadurch gekennzeichnet,**
**daß** das Kodiermodul (1) durch Befestigung eines der Kodierelemente (2) mittels einem Befestigungsmittel (18) an einem der zusammenfügbaren Teile (10) gehalten ist.

4. Kodiereinrichtung nach Anspruch 3, **dadurch gekennzeichnet,**
**daß** beim Zusammenfügen der Teile (10, 11) das andere Kodierelement (3) mittels Befestigungsmitteln (15) an dem anderen Teil (11) befestigbar ist.

5. Verfahren zum Kodieren von zwei mechanisch verbindbaren Teilen mit einer Kodiereinrichtung nach einem der vorstehenden Ansprüche, **dadurch gekennzeichnet,**
**daß** das Kodiermodul (1) mit dem Kodierelement (2) an dem ersten zu verbindenden Teil (10) befestigt wird,
**daß** beim Zusammenfügen des ersten und des zweiten Teiles (10, 11) das andere Kodierelement (3) mittels eines Befestigungsmittels (15) an dem zweiten Teil (11) fixiert wird, und
**daß** beim weiteren Zusammenfügen, die durch die Stege (4) beabstandet gehaltenen Kodierelemente (2, 3) des Kodiermoduls (1) gegeneinander gedrückt werden, wobei eine Druckkraft auf die Stege ausgeübt wird, so daß die Stege (4) zwischen den Kodierelementen (2, 3) des Kodiermoduls (1) durch die Einwirkung dieser Druckkraft zerbrechen, und wobei das Kodierelement (3) durch das Befestigungsmittel (15) an dem zweiten Teil (11) befestigt wird.

## Claims

1. A coding device for mechanically joinable parts, particularly printed circuit board plugged connectors, wherein each of the parts to be joined is provided with at least one coding element,
**characterised in that**
two paired coding elements (2, 3) in each case are constructed as a one-piece coding module (1), the coding elements being held together via ridge-like connecting members (4).

2. The coding device according to claim 1, **characterised in that**
the coding elements (2, 3) of the coding module (1) are maintained at a distance from one another by the ridge-like connecting members (4).

3. The coding device according to claim 1 or 2, **characterised in that**
the coding module (1) is held against one of the joinable parts (10) by fixing one of the coding elements (2) via fixing means (18).

4. The coding device according to claim 3, **characterised in that**
when the parts (10,11) are joined, the other coding element (3) is fixable to the other part (11) via fixing means (15).

5. A method for coding two mechanically joinable parts with a coding device according to any of the preceding claims,
**characterised in that**
the coding module (1) is affixed to first part to be joined (10) with the coding element (2),
when the first and second parts (10, 11) are joined, the other coding element (3) is fixed to the second part (11) via fixing means (15), and as the joining process progresses the coding elements (2, 3) of coding module (1) that are maintained with spacing by ridges (4) are pressed together, wherein a compressive force is exerted on the ridges so that the ridges (4) between the coding elements (2, 3) of the coding module (1) break under the effect of this compressive force, and
wherein the coding element (3) is affixed to the second part (11) via the fixing means (15).

## Revendications

1. Dispositif de codage pour des éléments pouvant être assemblés de façon mécanique, notamment des connecteurs de cartes de circuits imprimés, les éléments à assembler étant respectivement munis d'au moins un élément de codage, **caractérisé en ce que**
respectivement deux éléments de codage qui vont ensemble (2, 3) sont conçus en tant que module monobloc (1), les éléments de codage étant maintenus ensemble à l'aide de liaisons (4) du type de nervures.

2. Dispositif de codage selon la revendication 1, **caractérisé en ce que** les éléments de codage (2, 3) du module de codage (1) sont maintenus à une distance par les liaisons (4) du type de nervures.

3. Dispositif de codage selon la revendication 1 ou 2, **caractérisé en ce que** le module de codage (1) est maintenu par fixation de l'un des éléments de codage (2) à l'aide d'un moyen de fixation (18) sur l'un des éléments (10) pouvant être assemblés.

4. Dispositif de codage selon la revendication 3, **caractérisé en ce que** lors de l'assemblage des éléments (10, 11), l'autre élément de codage (3) peut être fixé sur l'autre élément (11), à l'aide de moyens de fixation (15).

5. Procédé de codage de deux éléments pouvant être assemblés de façon mécanique, avec un dispositif de codage selon l'une quelconque des revendications précédentes, **caractérisé en ce qu'**on fixe le module de codage (1) avec l'élément de codage (2) sur le premier élément (10) à assembler,
**en ce que** lors de l'assemblage du premier et du deuxième élément (10, 11) on fixe l'autre élément de codage (3) sur le deuxième élément (11), à l'aide d'un moyen de fixation (15) et
**en ce que** lors de la poursuite de l'assemblage, on presse l'un contre l'autre les éléments de codage (2, 3) du module de codage (1) qui sont maintenus à une distance, une force de compression étant exercée sur les nervures, pour que les nervures (4) entre les éléments de codage (2, 3) du module de codage (1) se brisent sous l'effet de cette force de compression et l'élément de codage (3) étant fixé par le moyen de fixation (15) sur le deuxième élément (11).
